# EUROPEAN PATENT APPLICATION

(11) **EP 2 871 153 A1**
(43) Date of publication of application: **13.05.2015**
(21) Application number: 13813230.3
(22) Date of filing: 03.07.2013
(51) Int. Cl.: C01B 21/072, B82B 3/00, B82Y 30/00, B32B 15/04, H01L 31/042

(54) **FORMULATION OF INKS CONTAINING CERAMIC NANOPARTICLES**

(30) Priority: 04.07.2012 ES 201231050
(71) Applicant: Abengoa Solar New Technologies, S.A., 41014 Sevilla (ES)
(72) Inventor: GUILERA GRANDES, Núria, E-08302 Mataró (ES); LÓPEZ GARCÍA, Laura, E-08302 Mataró (ES); FRANCESCH DE CASTRO, Laia, E-08302 Mataró (ES); DELGADO GARCÍA, José María, E-41014 Sevilla (ES); SÁNCHEZ CORTEZÓN, Emilio, E-41014 Sevilla (ES)
(74) Representative: Elzaburu S.L.P.
(86) International application number: PCT/ES2013/070460
(87) International publication number: WO 2014/006252

(57) **Abstract**

The present invention relates to formulations comprising aluminum nitride nanoparticles, at least one dispersant and at least one aqueous solvent, to the method for obtaining said formulations as well as to their use for obtaining a leveling barrier layer.

## Description

### Field of the Invention

The present invention belongs to the field of the formulation of ceramic nanoparticles in solution for manufacturing leveling barrier layers on a substrate.

### Background of the Invention

Metal substrates can be used in designing photovoltaic solar cells.

When manufacturing photovoltaic solar cells, the material that is used as the substrate must have a low surface roughness and be flat, and more critically so when the substrate used is a metal substrate. Otherwise the electrical contact between the rear electrode, the front electrode and the metal substrate, if it is produced, would create a local short circuit (pinhole) that negatively affects solar cell performance.

If the substrate is excessively rough, the roughness may prevent the deposition of the layers from uniformly and conformally covering the topology of the substrate, particularly when the layers that are deposited for forming the structure of the semiconductor are thin layers (in the order of hundredths of nanometers). In this case, there would be regions of the cell where contact between the interfaces of the deposited layers is not suitable, negatively affecting solar cell performance.

Another advantage of using substrates with a low surface roughness is that the effects of migration of unwanted impurities from the substrate to the subsequent active layers of the photovoltaic solar cell are minimized. Likewise, the presence of these impurities favors carrier recombination, negatively affecting solar cell performance.

In the case of metal substrates, there are no values in the literature that are accepted as universal criteria; there are related articles reporting an average surface roughness between 20 and 60 nm (Ra) [F. Kesslery D. Rudmann, "Technological aspects of flexible CIGS solar cells and modules", Solar Energy 77, 685 (2004); K. Otte et al, "Flexible Cu(Ga,In)Se2 thin-film solar cells for space application", Thin Solid Films 511-512, 613 (2006); N.G. Dhere et al, "Lightweight CIGS2 thin-film solar cells on stainless steel foil", 17th EUPVSEC (2001); and R. Wuerz et al, "CIGS thin-film solar cells on steel substrates", Thin Solid Films 517, 2415 (2009)]. Commercial suppliers of this material use similar values.

The metal substrates that can be used (titanium, different steel alloys, aluminum, etc...) contain inherent elements giving them their properties of hardness, conductibility, ductility, gloss, etc., but in some cases they are detrimental to solar cell operation, because during the thermal processes necessary for forming the cells, for example from Si, CIGSe (Copper Indium Gallium Selenium), CIS (Copper Indium Selenium), among others, metallic impurities spread from the substrate to the p-n junction of the semiconductor, favoring carrier recombination and showing a drastic decline in photoelectric efficiency. This is the case of iron, nickel or chromium, for example. However, dispensing with these materials is not evident: for example, nickel makes steel flexible, or chromium makes it moisture resistant.

It is therefore necessary to include in the design of the solar cell a layer that prevents the spread of these metallic impurities when the layered structure is subjected to thermal processes. To achieve this, a suitable material that does not react with the substrate or with the cell, that has a coefficient of thermal expansion similar to that of the semiconductor, a network structure that allows growth of the subsequent layers of the cell, and that has a microstructure that does not allow metallic elements to spread through them must be chosen.

Therefore, in the design of CIGS technology-based photovoltaic solar cells on flexible substrates, the optimal solution is to use metal substrates with a low surface roughness and inserting a leveling layer in the structure of the cell is an essential requirement to prevent the formation of short circuits and to impede metallic impurities from spreading from the substrate to the cell.

Document US 2004/0144419 A1 relates to the use of a barrier layer between the substrate and the electrode to prevent species from spreading from the substrate to the electrode. Said layers are based on a ceramic material, such as silicon nitride, silicon oxynitride, aluminum nitride, aluminum oxynitride, silicon oxide and silicon oxynitride. However, in said systems it is essential for the substrate to have a low surface roughness (or good flatness) to prevent short circuits and assure proper cell operation.

The barrier layers are conventionally deposited by physical means such as evaporation, e-beam (electron beam) or cathode sputter. However, the layer that is deposited is always conformal, i.e., it reproduces the morphology of the substrate, so it is not possible to compensate for surface defects. When using these methods thicker layers are not usually deposited because the process time needed would otherwise mean that the process is not cost-competitive, in addition to the high probability of the layer delamination due to accumulated stress.

The thickness of the absorbent layer involved in the design of CIGS technology-based solar cells is about 1 to 1.5 µm. It is therefore important for the substrate on which they are manufactured to have a low surface roughness, or in other words, good flatness. Otherwise, the peaks of the substrate could favor short circuits between the rear and front contact of the cell either due to electrical continuity between both layers or else due to the tunnel effect since the semiconductor material between them is not very thick.

Defining these specifications to metal substrate material suppliers entails the drawbacks of significantly reducing available suppliers, a high raw material cost and therefore a high end product cost, as well as having to have verification tools or a quality plan upon receiving the raw material.

It is therefore desirable to reduce the costs associated with solar cell production and the drawbacks mentioned above.

In this sense, the so-called doctor blade technique allows reducing costs associated with the production process because the substrate on which the layer is deposited does not have to have a very low surface roughness, since said technique allows depositing thicker layers. It therefore allows working with metal substrates that have a lower quality, at a lower raw material cost, and having a wider range of suppliers. By means of this technology, it is also possible to prevent the use of organic solvents and to prevent the formulations to be deposited from comprising water as a solvent or dispersing agent.

Although there are other deposition technologies for aqueous formulations, these technologies also entail certain problems. The so-called spin coating technique thus allows using said formulations and a thin layer thickness but is not a technique that is adaptable to mass production. In turn, screen printing allows using aqueous formulations and is adaptable to mass production, but small layer thicknesses necessary for obtaining a leveling layer are not obtained.

Furthermore, the deposition methods used in the state of the art comprise the use of organic solvents, which entails environmental problems.

An alternative for forming a leveling barrier layer on solid substrates is to use formulations based on nanoparticle dispersions. The factors that determine the properties of nanoparticle dispersions are the size and shape of the particles, the surface properties of the dispersion, interactions between particles, interactions between particles and molecules of the dispersion medium and interactions between particles and molecules of the medium with other possible molecules present that come from additives (dispersants or deflocculants, stabilizers, wetting agents). Nanoparticle dispersions must be homogenous and show stability over time and be readily redispersible, in addition to a small particle size and high wettability because their use is aimed at leveling the layer of the substrate. In addition to these characteristics, the systems to be formulated must have suitable viscosity and rheological behavior for being applied by means of the doctor blade technique.

### Brief Description of the Invention

The present invention provides a formulation comprising aluminum nitride nanoparticles for manufacturing leveling layers on rough, preferably metal, substrates said formulation being able to be deposited on said substrate by means of the doctor blade technique. In a particularly advantageous manner, the formulation of the present invention comprises water as a solvent. Choosing water as a solvent in the formulation of the ceramic layer prevents using organic solvents, and is therefore in accordance with the REACH (Registration, Evaluation, Authorization and Restriction of Chemical substances) regulation, which aims to assure a high level of protection for human and environmental health.

Furthermore, the formulation of the present invention is homogenous and stable over time, readily redispersible, shows high wettability and suitable viscosity and rheological behavior.

Therefore, in a first aspect the invention relates to a formulation comprising aluminum nitride nanoparticles, at least one dispersant and at least one aqueous solvent, where the aluminum nitride nanoparticles have a maximum size of 490nm.

In a second aspect, the invention relates to a method for obtaining a formulation according to the first aspect which comprises:
(a)providing the solvent(s);
(b)mixing the dispersant(s) with the solvent(s) of step (a); and
(c)mixing the aluminum nitride nanoparticles with the mixture of step (b).

In a third aspect, the invention relates to the use of a formulation as defined in the first aspect for obtaining a leveling barrier layer on a substrate.

### Description of the Drawings

Figure 1 shows the rheological characterization of Formulation A of Example 1.
Figure 2 shows the rheological characterization of Formulation B of Example 3.

### Detailed Description of the Invention

### Formulations

In a first aspect, the invention relates to a formulation comprising aluminum nitride nanoparticles, at least one dispersant and at least one aqueous solvent.

In one embodiment of the invention, the by weight ratio of the dispersant(s) with respect to the weight of aluminum nitride nanoparticles is comprised between 0.001 and 5, and the by weight ratio of the solvent (s) with respect to the weight of aluminum nitride nanoparticles is comprised between 25 and 50. Preferably, the by weight ratio of the dispersant(s) with respect to the weight of aluminum nitride nanoparticles is comprised between 0.01 and 5, more preferably between 0.05 and 1. Preferably, the by weight ratio of the solvent(s) with respect to the weight of aluminum nitride nanoparticles is comprised between 35 and 50. In a particular embodiment, the by weight ratio of the dispersant(s) with respect to the weight of aluminum nitride nanoparticles is comprised between 0.05 and 1, and the by weight ratio of the solvent (s) with respect to the weight of aluminum nitride nanoparticles is comprised between 35 and 50.

The by weight ratio refers to the ratio between the weight of the mentioned component of the formulation and the weight of aluminum nitride nanoparticles of the formulation.

The aluminum nitride nanoparticles preferably have a maximum size comprised in the range of 1 nm and 490 nm, more preferably between 2 nm and 350 nm, more preferably between 5 nm and 200 nm, even more preferably between 8 nm and 100 nm and even more preferably between 10 nm and 50 nm. In a particular embodiment of the invention, the aluminum nitride nanoparticles have a maximum size of 40 nm.

In the context of the present invention, the maximum size of the nanoparticles refers to the maximum mean diameter thereof.

The dispersants favor the homogeneity of the nanoparticles in the polymer-solvent combination. They are preferably polymeric and are preferably selected from polyacrylic acid salts and sulfated polymer salts.

The polyacrylic acid salts refer to polymers of the -CH₂-CH(COOM)- monomer, where M is selected from the group consisting of sodium, potassium, lithium and ammonium.

The sulfated polymer salts refer to alkyl sulfate salts and corresponding cations, such as sodium, potassium and ammonium cations for example. Examples of sulfated polymer salts are sodium dodecyl sulfate, ammonium dodecyl sulfate, preferably sodium dodecyl sulfate.

In a preferred embodiment of the invention, the dispersant is the polyacrylic acid sodium salt.

The aqueous solvent of the formulations of the present invention is selected from the group consisting of water and mixtures of water and organic solvents.

In the context of the present invention, a solvent consisting of water or a mixture of solvents comprising water, where water is the major component of said mixture, must be understood as an aqueous solvent. Therefore, the mixture of water and organic solvents must be understood as a mixture where water is the major component. Preferably, it is a mixture comprising at least 60% by weight of water with respect to the total weight of the mixture of aqueous solvent, more preferably at least 70%, more preferably at least 80%, even more preferably at least 90%, even more preferably at least 95%, most preferably at least 99%.

In the context of the present invention, the organic solvents refer to alcohols, ketones and esters.

In term "alcohol" refers to organic hydrocarbon compounds containing between 1 and 6 carbon atoms having a hydroxyl group. Examples of alcohols are methanol, ethanol, isopropanol, 1-propanol, butanol, among others.

The term "ketone" refers to organic hydrocarbon compounds containing between 1 and 6 carbon atoms having a ketone group, they can furthermore be optionally substituted with one or several hydroxyl groups. Examples of ketones are methylethylketone and diacetone alcohol, among others.

The term "ester" refers to carboxylic acid compounds containing between 1 and 6 carbon atoms esterified with an alcohol containing between 1 and 4 carbon atoms. Examples of esters are ethyl acetate and isobutyl acetate, among others.

In a preferred embodiment of the invention, the solvent consists of water.

Choosing an aqueous solvent as a solvent in the formulation of the ceramic layer prevents using organic solvents, and is therefore in accordance with the REACH (Registration, Evaluation, Authorization and Restriction of Chemical substances) regulation, which aims to assure a high level of protection for human and environmental health.

In one embodiment of the invention, the formulation further comprises at least one wetting agent.

Wetting agents allow controlling wettability or the contact angle of the composition according to the invention. There is a wide range of wetting agents known by the person skilled in the art. Preferably, the wetting agents are selected from hydrophilic polymeric substances, such as anionic or non-ionic surfactants, such as for example, polyethylene glycol derivatives (for example, polyethylene glycol alkyl ethers and oxyethylene polymers), polyols, fatty acid ethoxylates and siloxanes. Preferably, the wetting agents are selected from polyethylene glycol alkyl ethers, oxyethylene polymers, siloxanes and polyols. Preferably, the wetting agents are selected from polyethylene glycol alkyl ethers, oxyethylene polymers and polyols. More preferably, the wetting agents are selected from Triton X100 (polyethylene glycol tert-octyl ether with a mean molecular weight of 625 g/mol), PEG 400 (polyethylene glycol with a mean molecular weight of 400 g/mol), glycerol and mixtures thereof.

In the context of the present invention, the term "alkyl" refers to a linear- or branched-chain hydrocarbon radical consisting of carbon and hydrogen atoms, that does not contain unsaturation, that has 1 to 20 carbon atoms, preferably 1 to 12 carbon atoms, and that is bound to the rest of the molecule by means of a single bond, for example, methyl, ethyl, n-propyl, isopropyl, n-butyl, isobutyl, sec-butyl, tert-butyl, n-pentyl, isopentyl, sec-pentyl, *tert-*pentyl, n-hexyl, isohexyl, sec-hexyl, tert-hexyl, n-heptyl, isoheptyl, sec-heptyl, tert-heptyl, n-octyl, isooctyl, *sec-*octyl, tert-octyl, etc. The alkyl radicals can optionally be substituted with one or more substituents such as halogen, hydroxyl, alkoxyl, O-propyl, O-benzyl, O-benzoate, carboxyl, cyano, carbonyl, acyl, alkoxycarbonyl, amino, imino, nitro, mercapto and alkylthio.

In the context of the present invention, the term "oxyethylene polymers" refers to compounds having an H-(OCH₂CH₂)ₙ-OH structure, preferably with a molecular weight comprised between 200 g/mol and 600 g/mol, even more preferably between 300 g/mol and 500 g/mol.

In the context of the present invention, the term "polyol" refers to hydrocarbon compounds with several hydroxyl groups. Examples of polyols are triols such as glycerol, diols such as ethylene glycol, sugar alcohols such as pentaerythritol, sorbitol, mannitol, maltitol, xylitol, lactitol and isomalt.

In the context of the present invention, the term "fatty acid ethoxylate" refers to a carboxylic acid containing between 6 and 30 carbon atoms, saturated or having 1 to 5 unsaturations, esterified with 1 to 20 oxyalkylenyl groups. Examples of fatty acid ethoxylates are oleic acid ethoxylate, lauric acid ethoxylate, among others.

In the context of the present invention, the term "siloxane" refers to hydrocarbon compounds comprising Si atoms in their structure bound to an oxygen atom, and they can furthermore be optionally substituted with alcohol, methyl, ethyl groups. Examples of siloxanes are additives such as TegoWet 270 or TegoWet500 from the company Evonik.

In another embodiment of the invention, the by weight ratio of the wetting agent (s) with respect to the weight of aluminum nitride nanoparticles is comprised between 0.2 and 2.5, preferably between 1 and 2, even more preferably between 1.1 and 1.6.

In another embodiment of the invention, the formulation further comprises at least one polymer. The presence of said polymer is optional. The polymer-free formulations have the advantage of having a lower energy cost because a curing step can be eliminated in the use of said formulations for obtaining a leveling barrier layer, as explained below.

However, polymers cause a reduction in viscosity and in surface tension in the resulting formulation, and therefore greater processing and wetting ease. Said polymers are preferably selected from polyvinylpyrrolidone (PVP), polyacrylic acid (PAA), hydrolyzed polyvinyl alcohol (PVA) and polyol resin derived from castor oil, among others. Preferably, the polymer is polyvinylpyrrolidone.

Polyvinylpyrrolidone is a polymer of the vinylpyrrolidone monomer with an average molecular weight comprised between 10,000 g/mol and 40,000 g/mol, preferably between 20,000 g/mol and 30,000 g/mol.

Polyacrylic acid is an anionic polymer of the acrylic acid monomer, with an average molecular weight comprised between 500 g/mol and 5000 g/mol, preferably between 1000 g/mol and 3500 g/mol, even more preferably between 1200 g/mol and 2200 g/mol.

Polyvinyl alcohol is a polymer of the vinyl alcohol monomer. Said polymer is obtained from polyvinyl acetate hydrolysis and therefore can be partially hydrolyzed, i.e., it can further comprise vinyl acetate monomer groups. The average molecular weight is comprised between 20,000 g/mol and 50,000 g/mol, preferably between 25,000 g/mol and 35,000 g/mol.

Polyol resin derived from castor oil refers to polymers comprising the castor oil monomer (or ricinoleic acid ester and glycerine), preferably in at least 80% with respect to the total weight of the polyol resin, more preferably in at least 85% of the total weight of the polyol resin, even more preferably in at least 90% of the total weight of the polyol resin.

In another embodiment of the invention, the by weight ratio of the polymer(s) with respect to the weight of aluminum nitride nanoparticles is comprised between 1 and 15, preferably between 5 and 15, even more preferably between 7 and 10.

In one embodiment of the invention, the formulation further comprises ceramic nanoparticles which are selected from the group consisting of silicon nitride (SiNₓ), aluminum oxide (Al₂O₃), silicon oxide (SiOₓ), silicon oxynitride (SiNₓO_{y}), aluminum oxynitride (AlNₓO_{y}), aluminum silicon nitride (AlSi_{y}Nₓ), aluminum silicon oxide (AlSiOₓ) and mixtures thereof. Preferably, said ceramic nanoparticles are selected from aluminum oxide, silicon nitride and mixtures thereof.

In another embodiment of the invention, the by weight ratio of the ceramic nanoparticles defined above, preferably selected from the group consisting of silicon nitride, aluminum oxide and mixtures thereof with respect to the weight of aluminum nitride nanoparticles is comprised between 0.5 and 2.

Preferably, the maximum size of each type of ceramic nanoparticles mentioned above is comprised in the range of 1 nm and 900 nm, more preferably between 10 nm and 500 nm, more preferably between 10 nm and 50 nm, even more preferably between 10 nm and 30 nm. In a particular embodiment of the invention, the ceramic nanoparticles mentioned above have a maximum size of 20 nm.

The proportion of aluminum nitride nanoparticles with respect to silicon nitride, aluminum oxide, silicon oxide, silicon oxynitride, aluminum oxynitride, aluminum silicon nitride, aluminum silicon oxide nanoparticles and mixtures thereof is comprised in the range of 100:0 to 60:40, preferably 100:0 to 80:20, more preferably 100:0 to 90:10.

In a preferred embodiment of the invention, the nanoparticles comprised in the formulations defined above have the same maximum size. For example, in a formulation comprising aluminum nitride nanoparticles, said nanoparticles all have the same maximum size. Another example is a formulation comprising aluminum nitride nanoparticles and another type of nanoparticles selected from silicon nitride, aluminum oxide, silicon oxide, silicon oxynitride, aluminum oxynitride, aluminum silicon nitride, aluminum silicon oxide and mixtures thereof, preferably silicon nitride, aluminum oxide and mixtures thereof, where all the nanoparticles of one and the same type have the same maximum size, and the different types of nanoparticles furthermore have the same maximum size. In a preferred embodiment, the maximum size of the nanoparticles of the formulation is comprised between 1 nm and 490 nm, more preferably between 2 nm and 350 nm, more preferably between 5 nm and 200 nm, even more preferably between 8 nm and 100 nm and even more preferably between 10 nm and 50 nm.

In another preferred embodiment of the invention, the nanoparticles comprised in the formulations defined above have a different maximum size. For example, in a formulation comprising aluminum nitride nanoparticles, said nanoparticles have a different maximum size. Another example is a formulation comprising aluminum nitride nanoparticles and another type of nanoparticles selected from silicon nitride, aluminum oxide, silicon oxide, silicon oxynitride, aluminum oxynitride, aluminum silicon nitride, aluminum silicon oxide and mixtures thereof, preferably silicon nitride, aluminum oxide and mixtures thereof, where the nanoparticles of one and the same type have a different maximum size, and/or the different types of nanoparticles have a different maximum size. In a preferred embodiment, the maximum size of the nanoparticles of the formulation is comprised between 1 nm and 490 nm, more preferably between 2 nm and 350 nm, more preferably between 5 nm and 200 nm, even more preferably between 8 nm and 100 nm and even more preferably between 10 nm and 50 nm.

In the context of the present invention it must be understood that the nanoparticles have the same maximum size if their maximum size differs by less than 10%, preferably less than 5%, even more preferably less than 1%, still more preferably less than 0.5%, most preferably less than 0.05%. Alternatively, if the nanoparticles do not have the same maximum size under the preceding definition, it must be understood that said nanoparticles have different maximum sizes.

### Method for obtaining the formulations

In a second aspect, the invention relates to the method for obtaining a formulation of the invention, as defined above, which comprises:
(a)providing the solvent(s);
(b)mixing the dispersant(s) with the solvent(s) of step (a); and
(c)mixing the aluminum nitride nanoparticles with the mixture of step (b).

The solvent of step (a) is selected from the group consisting of water and mixtures of water and organic solvent, where the organic solvent is selected from alcohols, esters and ketones, as defined above. Preferably the solvent is water.

The dispersant(s) of step (b) is/are preferably selected from polyacrylic acid salts and sulfated polymer salts, as defined above. Preferably, the dispersant is polyacrylic acid sodium salt.

The dispersant of step (b) is mixed with the solvent of step (a) preferably under stirring, more preferably with a high-shear mixer. Said mixing can be performed in a temperature range comprised between 10 and 35°C, more preferably between 20 and 30°C.

In the event that the formulation of the invention comprises wetting agent(s), said wetting agent(s) is added to the mixture of the solvent(s) and dispersant(s) in step (b) of the method for obtaining the formulation. The dispersant(s) can be added first and then the wetting agent(s). Or the wetting agent(s) can be added first and then the dispersant(s). Or the dispersant (s) and the wetting agent (s) can be added simultaneously. Optionally, the obtained mixture is stirred after the addition of each of the dispersant(s) and the wetting agent(s). Preferably the addition and/or stirring is performed in a temperature range comprised between 10 and 35°C, more preferably between 20 and 30°C.

Preferably, the wetting agents are selected from hydrophilic polymeric substances, anionic or non-ionic surfactants, such as, polyethylene glycol, polyol, fatty acid ethoxylate and siloxane derivatives, as defined above, for example. Preferably, the wetting agents are selected from polyethylene glycol alkyl ethers, oxyethylene polymers, siloxanes and polyols. Preferably, the wetting agents are selected from polyethylene glycol alkyl ethers, oxyethylene polymers and polyols. Preferably, the wetting agents are selected from Triton X100 (polyethylene glycol tert-octyl ether with a mean molecular weight of 625 g/mol), PEG 400 (polyethylene glycol with a mean molecular weight of 400 g/mol), glycerol and mixture thereof.

In step (c) of the method for obtaining the formulation according to the invention the aluminum nitride nanoparticles are added to the mixture obtained in step (b) defined above.

The aluminum nitride nanoparticles preferably have a maximum size comprised in the range of 1 nm and 490 nm, more preferably between 2 nm and 350 nm, more preferably between 5 nm and 200 nm, even more preferably between 8 nm and 100 nm, even more preferably between 10 nm and 50 nm and even more preferably between 30 nm and 50 nm. In a particular embodiment of the invention, the aluminum nitride nanoparticles have a maximum size of 40 nm.

The nanoparticles incorporated into the formulation in step (c) are mixed with the mixture obtained in step (b) preferably under stirring, more preferably with a high-shear mixer. Said mixing can be performed in a temperature range comprised between 10 and 35°C, more preferably between 20 and 30°C. Said mixing is performed until obtaining a homogenous dispersion that is stable over time. Preferably, the obtained the method for obtaining the formulation according to the e invention the aluminum nitride nanoparticles ars and 45 minutes, even more preferably for 30 minutes.

In one embodiment of the invention, the by weight ratio of the dispersant(s) with respect to the weight of aluminum nitride nanoparticles is comprised between 0.001 and 5, and the by weight ratio of the solvent (s) with respect to the weight of aluminum nitride nanoparticles is comprised between 25 and 50. Preferably, the by weight ratio of the dispersant(s) with respect to the weight of aluminum nitride nanoparticles is comprised between 0.01 and 5, more preferably between 0.05 and 1. Preferably, the by weight ratio of the solvent(s) with respect to the weight of aluminum nitride nanoparticles is comprised between 35 and 50. In a particular embodiment, the by weight ratio of the dispersant(s) with respect to the weight of aluminum nitride nanoparticles is comprised between 0.05 and 1, and the by weight ratio of the solvent(s) with respect to the weight of aluminum nitride nanoparticles is comprised between 35 and 50.

In one embodiment of the invention, the formulation further comprises polymer(s). Therefore, the method for obtaining said formulations further comprises the addition of polymer(s) to the solvent(s) of step (a) and/or to the mixture of step (b), i.e., said polymer(s) can be added to the solvent(s) of step (a), to the mixture comprising solvent(s), dispersing agent(s) and optionally wetting agent(s) of step (b) or to both mixtures. The polymer(s) are preferably mixed with the other components of the formulation by means of stirring in a temperature range comprised between 10 and 35°C, more preferably between 20 and 30°C.

The polymers provide the system with uniform consistency and allow easier dispersion of the nanoparticles in the formulation. The polymers are optional, as indicated above, and are preferably selected from polyvinylpyrrolidone (PVP), polyacrylic acid (PAA), hydrolyzed polyvinyl alcohol (PVA) and polyol resin derived from castor oil, among others, as defined above. Preferably, the polymer is polyvinylpyrrolidone.

In one embodiment of the invention, the by weight ratio of the polymer(s) with respect to the weight of aluminum nitride nanoparticles is comprised between 1 and 15, preferably between 5 and 15, even more preferably between 7 and 10.

In one embodiment of the invention, the formulation further comprises ceramic nanoparticles that are selected from the group consisting of silicon nitride (SiNₓ), aluminum oxide (Al₂O₃), silicon oxide (SiOₓ), silicon oxynitride (SiNₓO_{y}), aluminum oxynitride (AlNₓO_{y}), aluminum silicon nitride (AlSi_{y}Nₓ), aluminum silicon oxide (AlSiOₓ) and mixtures thereof. Preferably, said ceramic nanoparticles are selected from aluminum oxide, silicon nitride and mixtures thereof. Therefore, the method for obtaining said formulations further comprises the addition of the ceramic nanoparticles to the mixture of step (b) and/or to the mixture of step (c), i.e., they are added to either the mixture comprising solvent(s), dispersing agent(s) and optionally wetting agent(s) of step (b), or else to the mixture comprising solvent(s), dispersing agent(s), optionally wetting agent(s) and aluminum nitride nanoparticles of step (c), or to both mixtures. The resulting formulation is mixed, for example, in a temperature range comprised between 10 and 35°C, more preferably between 20 and 30°C. Said mixing is performed until obtaining a homogenous dispersion that is stable over time. Preferably, the obtained mixture is stirred for a time period comprised between 5 minutes and 2 hours, preferably between 15 minutes and 45 minutes, even more preferably for 30 minutes.

The by weight ratio of the ceramic nanoparticles defined above, preferably selected from the group consisting of silicon nitride, aluminum oxide and mixtures thereof, with respect to the weight of aluminum nitride nanoparticles is comprised between 0.5 and 2.

Preferably, the maximum size of each type of ceramic nanoparticles mentioned above is comprised in the range of 1 nm and 900 nm, more preferably between 1 nm and 490 nm, more preferably between 2 nm and 350 nm. More preferably between between 5 nm and 200 nm. More preferably between 10 nm and 50 nm. Even more preferably between 10 nm and 30 nm. In a particular embodiment of the invention, the ceramic nanoparticles mentioned above have a maximum size of 20 nm.

The ratio of aluminum nitride nanoparticles with respect to silicon nitride, aluminum oxide, silicon oxide, silicon oxynitride, aluminum oxynitride, aluminum silicon nitride, aluminum silicon oxide nanoparticles and mixtures thereof is comprised in the range of 100:0 to 60:40, preferably of 100:0 to 80:20, more preferably of 100:0 to 90:10.

In one embodiment, the nanoparticles comprised in the formulations defined above have the same maximum size. For example, in a formulation comprising aluminum nitride nanoparticles, said nanoparticles all have the same maximum size. Another example is a formulation comprising aluminum nitride nanoparticles and another type of nanoparticles selected from silicon nitride, aluminum oxide, silicon oxide, silicon oxynitride, aluminum oxynitride, aluminum silicon nitride, aluminum silicon oxide and mixtures thereof, preferably silicon nitride, aluminum oxide and mixtures thereof, where all the nanoparticles of one and the same type have the same maximum size, and the different types of nanoparticles furthermore have the same maximum size. In a preferred embodiment, the maximum size of the nanoparticles of the formulation is comprised between 1 nm and 490 nm, more preferably between 2 nm and 350 nm, more preferably between 5 nm and 200 nm, even more preferably between 8 nm and 100 nm and even more preferably between 10 nm and 50 nm.

In another embodiment, the nanoparticles comprised in the formulations defined above have a different maximum size. For example, in a formulation comprising aluminum nitride nanoparticles, said nanoparticles have a different maximum size. Another example is a formulation comprising aluminum nitride nanoparticles and another type of nanoparticles selected from silicon nitride, aluminum oxide, silicon oxide, silicon oxynitride, aluminum oxynitride, aluminum silicon nitride, aluminum silicon oxide and mixtures thereof, preferably silicon nitride, aluminum oxide and mixtures thereof, where the nanoparticles of one and the same type have a different maximum size and/or the different types of nanoparticles have a different maximum size. In a preferred embodiment, the maximum size of the nanoparticles of the formulation is comprised between 1 nm and 490 nm, more preferably between 2 nm and 350 nm, more preferably between 5 nm and 200 nm, even more preferably between 8 nm and 100 nm and even more preferably between 10 nm and 50 nm.

Optionally, the formulations obtained by means of the method according to the invention can be filtered to prevent clumping.

The formulations of the present invention can further comprise other components, such as plasticizers, antifoaming agents, bactericides, among others.

### Use of the formulations

In a third aspect, the invention relates to the use of a formulation of the invention for obtaining a leveling barrier layer on a substrate.

In the context of the present invention, the term "barrier layer" refers to a surface that impedes the passage of impurities from a substrate (preferably a metal substrate) on which said barrier layer has been deposited.

In general, said leveling barrier layer is deposited on a substrate, generally a substrate commonly used in the field of solar cells, such as a metal substrate for example.

The leveling characteristic of the layer compensates for substrate surface irregularities, i.e., it impedes reproducing defects in the topology of the substrate in the deposited layer. Said defects, for example in the field of solar cells affect the performance thereof. The leveling barrier layer obtained by means of using a formulation according to the present invention furthermore impedes the passage of impurities from the metal substrate on which it has been deposited to the solar cell when subjected to thermal processes commonly used in manufacturing said cells. Furthermore, the leveling barrier layer according to the invention favors thermal dissipation due to the thermal properties of aluminum nitride, thereby achieving a lower working temperature range.

The deposition of the formulation according to the invention is performed by means of the doctor blade technique, i.e., by means of a blade that is secured to a head and slides over a platform containing the substrate, and the formulation to be deposited is located in said substrate.

The thickness of the layer is directly related to the blade positioning angle, blade hardness, the distance between blade and substrate and the driving speed. Preferably, the layer has a thickness greater than or equal to 500 nm.

The blade positioning angle is comprised in the range of 45° to 75°. Preferably, the blade positioning angle is selected from 45°, 50°, 55°, 60° and 75°. More preferably, the blade positioning angle is 55°.

Blade hardness is a property related to the material of said blade. Preferably, the blade has a Brinell hardness number between 100 and 300, more preferably it is 160. Preferably, the blade is made of stainless steel.

The distance between the blade and the substrate is comprised in the range of 0.05 mm a 0.15 mm. Preferably, the distance between the blade and the substrate is selected from 0.05 mm, 0.10 mm or 0.15 mm. More preferably, the distance between the blade and the substrate is 0.05 mm.

The driving speed is comprised in the range of 0.07 m/s and 0.7 m/s. Preferably, the driving speed is constant and is 0.2 m/s.

Once the layer is deposited, it is subjected to a thermal treatment performed at temperatures comprised in the range of 400°C and 750°C, preferably between 550°C and 650°C, more preferably at 600°C. The thermal treatment is performed in an air, argon, nitrogen atmosphere, preferably in an air atmosphere; during a range of time comprised between 40 seconds and 15 minutes, preferably for 1 minute.

If the formulation deposited on the substrate comprises polymer(s), prior thermal treatment is performed at temperatures comprised in the range of between 70°C and 250°C, preferably between 100°C and 150°C; for 5 minutes and 45 minutes; preferably between 5 minutes and 15 minutes; in an air, argon or nitrogen atmosphere, preferably in an air atmosphere.

In the context of the present invention, the corresponding parameter value ranges are expressed comprised between two values or ends. Said ranges include the values of the ends in addition to the intermediate values defined by said ends.

The following examples are merely illustrative and must not be considered as limiting examples of the invention.

### Examples

### Materials and methods

*Mixer:* The formulations are mixed with a Silverson L5M high-shear mixer; the system allows maximum stirring of 8000 rpm, selecting 3000 rpm for the stirring of the mixtures.
*Contact angle:* The contact angle is measured with a Krüss DSA100 instrument. The system allows measuring the contact angle, surface tension and surface energy.
*Rheometer:* The viscosity is measured by means of the Anton Paar Physica MCR 301 rheometer. The method is based on applying a plurality of shear velocities and measuring the shear stress for each velocity.
*Mechanical surface profiler:* The layer roughnesses are measured with a Veeco Dektak 150 mechanical surface profiler. The system has a vertical resolution of 5 to 10 nm, a tip radius of curvature of 2 µm and a tip force of 0.03-15 mg. The method used is based on measuring a span of 2000 µm with a force of 3 mg.

### Example 1. Preparation of formulation A

0.15 g of polyacrylic acid sodium salt (Sigma Aldrich) is added to 9.2 g of Milli-Q water in a 25 mL beaker and is stirred at room temperature with the high-shear mixer until obtaining a solution. Then 0.13 g Triton X100 (Sigma Aldrich, polyethylene glycol tert-octyl ether with a mean molecular weight of 625 g/mol) and 0.18 g of PEG400 (Sigma Aldrich, polyethylene glycol with a mean molecular weight of 400 g/mol) are added. The mixture is stirred in the high-shear mixer at room temperature until obtaining a solution. Next, 0.2 g of AlN nanoparticles having a diameter of less than 40 nm (Sky Spring Nanomaterials) are added, and the mixture is stirred for 30 minutes in the high-shear mixer at room temperature and the obtained mixture is filtered with a 0.2 µm sieve.

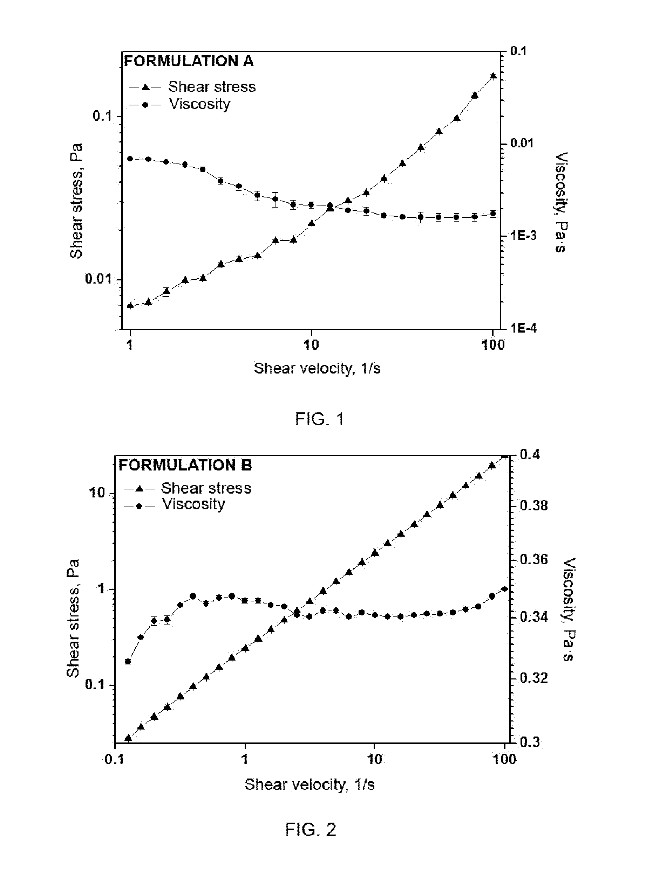

Obtained formulation A has a contact angle of 40° and a viscosity of 3 mPa·s (at a shear velocity of 100 s⁻¹). Figure 1 shows the rheological characterization graph (shear stress and viscosity).

### Example 2. Deposition of formulation A

The doctor blade deposition equipment provided with a stainless steel blade is calibrated at a blade height (gap) of 0.05 mm, inclination of 55°. Then the stainless steel substrate (SS430 standard roughness, Ra 204 nm) is placed on the deposition equipment sample holder. 0.1 mL of formulation A prepared in Example 1 is added by metering with a syringe. The velocity in the deposition equipment is adjusted, and the bar is ordered to move forward, a layer of formulation A being obtained on the metal substrate. Then it is dried in the muffle for 1 minute at 600°C. The process is repeated: 0.05 mL of formulation A prepared in Example 1 is added by metering with a syringe. The velocity in the deposition equipment is adjusted, and the bar is ordered to move forward, a second layer of formulation A being obtained on the metal substrate. Then it is dried in the muffle for 1 minute at 600°C. The deposited layer is characterized with the Veeco Dektak 150 mechanical surface profiler.

AlN layer thickness = 1 µm; initial substrate roughness - 208 nm; deposited formulation A layer roughness = 106 nm.

### Example 3. Preparation of formulation B

0.1 g of polyacrylic acid sodium salt (Sigma Aldrich) and 1.8 g of polyvinylpyrrolidone (Sigma Aldrich) are added to 7.8 g of Milli-Q water in a 25 mL beaker and is stirred at room temperature with a high-shear mixer until obtaining a solution. Then 0.09 g Triton X100 (Sigma Aldrich, polyethylene glycol tert-octyl ether with a mean molecular weight of 625 g/mol), 0.1 g of PEG400 (Sigma Aldrich, polyethylene glycol with a mean molecular weight of 400 g/mol) and 0.05 g of glycerol (Sigma Aldrich with a mean molecular weight of 92 g/mol) are added. The mixture is stirred in the high-shear mixer at room temperature until obtaining a solution. Next, 0.2 g of AlN nanoparticles having a diameter of less than 100 nm (Sigma Aldrich) are added, and the mixture is stirred for 30 minutes in the high-shear mixer at room temperature.

Obtained formulation B has a contact angle of 40° and a viscosity of 0.18 Pa·s (at a shear velocity of 100s⁻¹). Figure 2 shows the rheological characterization graph (shear stress and viscosity).

### Example 4. Deposition of formulation B

The doctor blade deposition equipment provided with a stainless steel blade is calibrated at a blade height (gap) of 0.05 mm, inclination of 55°. Then the metal substrate (SS 430 standard roughness, Ra 204 nm) is placed on the deposition equipment sample holder. 0.1 mL of formulation B prepared in Example 3 is added by metering with a syringe. The velocity in the deposition equipment is adjusted, and the bar is ordered to move forward, a layer of formulation B being obtained on the metal substrate. The substrate with formulation B deposited thereon is placed in an orbital shaker for 30 minutes at 560 rpm. Then it is subjected to an oven curing at 130°C for 10 minutes and in an air atmosphere. Finally it is dried in the muffle for 1 minute at 600°C. The deposited layer is characterized with the Veeco Dektak 150 mechanical surface profiler.

AlN layer thickness = 1 µm; initial substrate roughness - 208 nm; deposited formulation B layer roughness =180 nm.

## Claims

1. A formulation comprising aluminum nitride nanoparticles, at least one dispersant and at least one aqueous solvent, where the aluminum nitride nanoparticles have a maximum size of 490nm.

2. The formulation according to claim 1, wherein the by weight ratio of the dispersant(s) with respect to the weight of aluminum nitride nanoparticles is comprised between 0.001 and 5 and the by weight ratio of the solvent (s) with respect to the weight of aluminum nitride nanoparticles is comprised between 25 and 50.

3. The formulation according to any of the preceding claims, wherein the dispersant is selected from the group consisting of polyacrylic acid salts and sulfated polymer salts.

4. The formulation according to any of the preceding claims, wherein the aqueous solvent is selected from the group consisting of water and mixtures of water and organic solvent, wherein the organic solvent is selected from alcohols, ketones and esters.

5. The formulation according to claim 4, wherein the aqueous solvent consists of water.

6. The formulation according to any of claims 1 to 5, where the aluminum nitride nanoparticles have a maximum size between 2 nm and 350 nm.

7. The formulation according to any of claims 1 to 6 where the aluminum nitride nanoparticles have a maximum size between 10 nm and 50 nm.

8. The formulation according to any of the preceding claims, further comprising at least one wetting agent.

9. The formulation according to claim 8, wherein the wetting agents are selected from the group consisting of polyethylene glycol alkyl ethers, oxyethylene polymers, siloxanes and polyols.

10. The formulation according to any of claims 8 to 9, wherein the by weight ratio of the wetting agent(s) with respect to the weight of aluminum nitride nanoparticles is comprised between 0.2 and 2.5.

11. The formulation according to any of the preceding claims, further comprising at least one polymer.

12. The formulation according to claim 11, wherein the polymer is selected from the group consisting of polyvinylpyrrolidone, polyacrylic acid, polyvinyl alcohol, polyol resin, and mixture thereof.

13. The formulation according to any of claims 11 to 12, wherein the by weight ratio of the polymer(s) with respect to the weight of aluminum nitride nanoparticles is comprised between 1 and 15.

14. The formulation according to any of the preceding claims, further comprising nanoparticles that are selected from the group consisting of silicon nitride, aluminum oxide and mixtures thereof.

15. The formulation according to claim 14, wherein the by weight ratio of the nanoparticles selected from the group consisting of silicon nitride, aluminum oxide and mixtures thereof with respect to the weight of aluminum nitride nanoparticles is comprised between 0.5 and 2.

16. The formulation according to any of claims 14 to 15, wherein the maximum size of the nanoparticles that are selected from the group consisting of silicon nitride, aluminum oxide and mixtures thereof, are comprised between 1 nm and 900 nm.

17. The formulation according to claim 16, wherein the maximum size of the aluminum nitride nanoparticles and the nanoparticles that are selected from the group consisting of silicon nitride, aluminum oxide and mixtures thereof, are comprised between 2 nm and 350 nm.

18. A method for obtaining a formulation as defined in any of the preceding claims which comprises:
(a)providing the solvent(s);
(b)mixing the dispersant(s) with the solvent(s) of step (a); and
(c)mixing the aluminum nitride nanoparticles with the mixture of step (b).

19. The method according to claim 18, further comprising the addition of at least one wetting agent to the mixture of step (b).

20. The method according to any of claims 18 to 19, further comprising the addition of polymer(s) to the solvent(s) of step (a) and/or to the mixture of step (b).

21. The method according to any of claims 18 to 20, further comprising the addition of nanoparticles that are selected from the group consisting of silicon nitride, aluminum oxide and mixtures thereof to the mixture of step (b) and/or to the mixture of step (c).

22. Use of a formulation as defined in any of claims 1 to 17 for obtaining a leveling barrier layer on a substrate.
